# EUROPEAN PATENT APPLICATION

(11) **EP 1 898 223 A1**
(43) Date of publication of application: **12.03.2008**
(21) Application number: 07110817.9
(22) Date of filing: 21.06.2007
(51) Int. Cl.: G01R 1/073, G01R 3/00

(54) **Probe substrate for test and manufacturing method thereof**

(30) Priority: 08.09.2006 KR 20060086719
(71) Applicant: Apex International, Inc., Suwon City, Kyungki-do (KR)
(72) Inventor: Rhyu, Dal-Lae 412-1906 Poonglim Apt.,, SUWON-SI, GYEONGGI-DO (KR)
(74) Representative: Modiano, Micaela Nadia

(57) **Abstract**

A probe substrate includes a plurality of beams, a probe having a contactor formed at one end of the beam, and a support substrate supporting the probe and having a bending space in which the probe can be bent upwards and downwards, and a trench oxide layer is formed on the upper surface of the support substrate. Therefore, the probe substrate and a manufacturing method thereof according to the present invention forms a trench oxide layer on the boundary of the beam and the support substrate to prevent the boundary from being damaged by stress applied to the boundary during a continuous and repeated bending process of the beam. Therefore, electrical insulation between the beam and the support substrate is maintained to prevent electrical leakage.

## Description

### BACKGROUND OF THE INVENTION

### (a) Field of the Invention

The present invention relates to a probe substrate and a manufacturing method thereof, and more particularly relates to a probe substrate including a probe for electrically testing a semiconductor integrated circuit (IC) device formed on a semiconductor wafer, and a manufacturing method thereof.

### (b) Description of the Related Art

In general, a semiconductor integrated circuit (IC) device is made using a predetermined semiconductor manufacturing process. An electrical test is applied during or after the manufacturing process to determine what products are non-functional. In the electrical test, a test equipment for receiving various electrical signals from the outside, detecting response signals of the semiconductor integrated circuit, and analyzing the response signals is used, and a probe for electrically connecting the test equipment and the semiconductor integrated circuit is needed. A similar test process is performed during or after the manufacturing process of flat panel displays such as the liquid crystal displays (LCDs), and a probe for electrically connecting the test equipment and elements is also needed.

A predetermined part of a support substrate for supporting the probe is etched to form a bending space, thus the probe may have elastic properties. An oxide layer is formed at the region between the probe and the support substrate for providing electrical insulation. However, the repeated bending operation of the probe generates stress to the boundaries between the probe and the support substrate, and thus the oxide layer may be damaged. The electrical insulation between the probe and the support substrate is damaged to generate electricity leakage that may damage the probe substrate and deteriorate a test quality of the probe substrate.

### SUMMARY OF THE INVENTION

Accordingly, the present invention has been made to solve the above-mentioned problems occurring in the prior art, and an object of the present invention is to provide a probe substrate for generating no electrical insulation damage by a repeated bending operation between a probe and a support substrate, and a manufacturing method thereof.

In one embodiment of the present invention, a probe substrate includes a probe including a beam having a first end and a second end and a contactor formed at the first end of the beam; a support substrate supporting the second end of the probe and having a bending space in which the first end of the probe is bent upwards and downwards; and a trench oxide layer formed on the upper surface of the support substrate, wherein the trench oxide layer is disposed adjacent to the bending space among the parts in which the support substrate supports the probe. The beam and part of the support substrate are separated with a predetermined gap therebetween by the bending space. A through hole is formed in the support substrate, and the through hole is filled by a connection member.

The trench oxide layer is a thermal oxide layer formed at a plurality of microtrenches on the support substrate surface. The beam is made of one metal of nickel (Ni), copper (Cu), platinum (Pt), palladium (Pd), rhodium (Rh), and gold (Au), or an alloy made of one of the metals as a major element and other metals as minor elements. An insulation layer is formed on the surface of the support substrate other than on the surface of the bending space of the support substrate. The insulation layer is formed at a region between the support substrate and the beam, and the connection member contacts with the beam. The longitudinal direction of the trench oxide layer is perpendicular to the longitudinal direction of the beam.

An auxiliary trench oxide layer is formed around the connection member, and the longitudinal direction of the auxiliary trench oxide layer is perpendicular to the longitudinal direction of the trench oxide layer.

In another embodiment of the present invention, a method for manufacturing a probe substrate includes forming a plurality of microtrenches on a support substrate; filling the microtrenches with a thermal oxide layer to form a trench oxide layer; forming a plurality of through holes in the support substrate; forming an insulation layer on the surface of the support substrate; forming a connection member in the through hole; forming a plurality of beams on the insulation layer formed on the support substrate; forming a contactor at one end of the beam; and etching a predetermined part of the support substrate provided at a lower part of the beam to form a bending space for enabling an end part at which the contactor of the beam is formed to move upwards and downwards, wherein the forming of a trench oxide layer includes controlling the trench oxide layer to be provided adjacent to the bending space among the part in which the support substrate supports the beam. The forming of a plurality of beams includes patterning the insulation layer formed on the support substrate and exposing a predetermined part of the support substrate corresponding to the bending space; forming a sacrificial metal layer on the exposed part of the support substrate; forming a seed layer on the sacrificial metal layer and the insulation layer; forming a first photoresist layer pattern on the seed layer and exposing a predetermined part of the seed layer; and filling the part exposed through the first photoresist layer pattern with metal by using an electroplating method, to form a plurality of beams. The first photoresist layer pattern includes a plurality of long bar patterns in the horizontal direction. One end of the long bar pattern of the first photoresist layer pattern corresponds to the connection member. The patterned insulation layer covers the trench oxide layer and the connection member. The sacrificial metal layer does not cover the trench oxide layer. The method further includes forming an auxiliary trench oxide layer around the through hole, and the longitudinal direction of the auxiliary trench oxide layer is perpendicular to the longitudinal direction of the trench oxide layer. Etching a predetermined part of the support substrate to form a bending space includes etching the sacrificial metal layer to form a space between the beam and the support substrate, and etching the support substrate exposed through the space and forming the bending space. The contactor is formed on the beam by using an electroplating method. The beam is made of one metal of nickel (Ni), copper (Cu), platinum (Pt), palladium (Pd), rhodium (Rh), and gold (Au), or an alloy made of one of the metals as a major element and other metals as minor elements.

### BRIEF DESCRIPTION OF THE DRAWINGS

The above and other objects, features, and advantages of the present invention will be more apparent from the following detailed description taken in conjunction with the accompanying drawings, in which:
FIG. 1A is a top plan view of a probe substrate according to an embodiment of the present invention;
FIG. 1 B is a cross-sectional view taken along the line Ib-Ib of FIG. 1A;
FIG. 2A is a top plan view of a probe substrate manufacturing method according to an embodiment of the present invention; FIG. 2B is a cross-sectional view taken along the line llb-llb of FIG. 2A;
FIG. 3 is a cross-sectional view showing a next step of FIG. 2B;
FIG. 4A is a top plan view showing a next step of FIG. 3;
FIG. 4B is a cross-sectional view taken along the line IVb-IVb of FIG. 4A;
FIG. 5 is a cross-sectional view showing a next step of FIG. 4B;
FIG. 6A is a top plan view showing a next step of FIG. 5;
FIG. 6B is a cross-sectional view taken along the line Vlb-Vlb of FIG. 6A;
FIGs. 7 to 11 sequentially illustrate cross-sectional views showing next steps of FIG. 6B;
FIG. 12A is a top plan view showing a next step of FIG. 11;
FIG. 12B is a cross-sectional view taken along the line Xllb-Xllb of FIG. 12A;
FIG. 13A is a top plan view showing a next step of FIG. 12A;
FIG. 13B is a cross-sectional view taken along the line XIIIb-XIIIb of FIG, 13A;and
FIGs. 14 to 18 sequentially illustrate cross-sectional views showing a next step of FIG. 13B.

### DETAILED DESCRIPTION OF THE EMBODIMENT

Hereinafter, a preferred embodiment of the present invention will be described with reference to the accompanying drawings. As those skilled in the art would realize, the described embodiments may be modified in various different ways, all without departing from the spirit or scope of the present invention. In the following description of the present invention, a detailed description of known functions and configurations incorporated herein will be omitted when it may make the subject matter of the present invention unclear.

A probe substrate and a manufacturing method thereof according to a preferred embodiment of the present invention will now be described with reference to drawings.

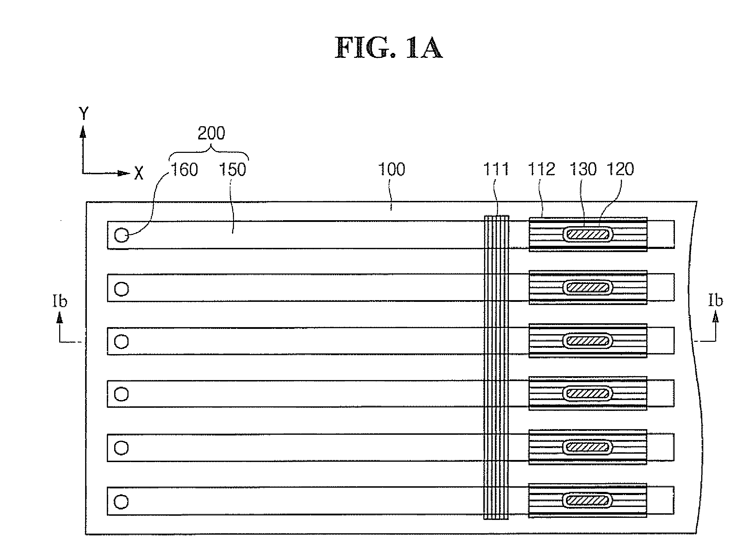

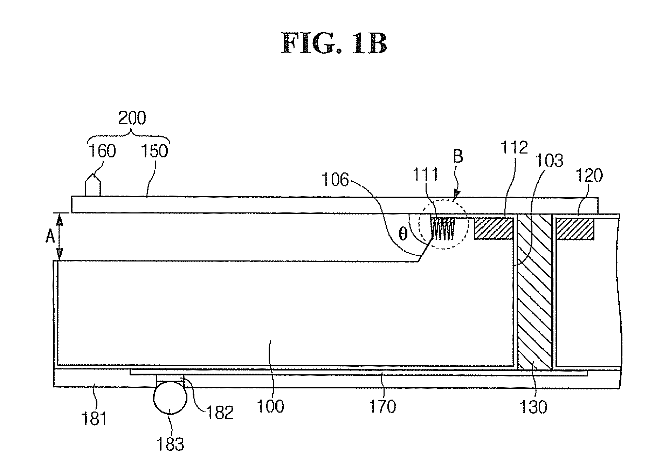

FIG. 1A is a top plan view of a probe substrate according to a preferred embodiment of the present invention, and FIG. 1B is a cross-sectional view taken along the line lb-lb of FIG. 1 A.

As shown in FIGS. 1A and 1B, the probe substrate includes a support substrate 100, and a probe 200 provided on the support substrate 100.

The support substrate 100 is preferably made of a single crystal silicon wafer, and an insulation layer 120 is formed on the surface of the support substrate 100.

A trench oxide layer 111 is formed around an upper surface of the support substrate 100, a through hole 103 is formed with a predetermined distance from the trench oxide layer 111, and a connection member 130 fills the through hole 103. The trench oxide layer 111 is generated by using a thermal oxide layer, thereby providing excellent electrical insulation and hardness.

The probe 200 includes a beam 150 electrically connected to the connection member 130 of the support substrate 100, and a contactor 160 formed at the one end of the beam 150 and attached to the beam 150 in a vertical direction. The beam 150 is made of one metal of nickel (Ni), copper (Cu), platinum (Pt), palladium (Pd), rhodium (Rh), and gold (Au), or an alloy made of one of the metals as a major element and other metal elements. An end of the contactor 160 is rounded so that the contactor may enable micro contact and no contaminants may be accumulated during the repeated contact process.

The contactor 160 electrically connects the probe substrate of a test equipment with the semiconductor integrated circuit in the electrical test.

The predetermined part of the support substrate 100 provided on the lower part of the beam 150 is removed to form a bending space (A) in which the beam 150 is bent upwards and downwards. The beam 150 and the predetermined part of the support substrate 100 are spaced with a predetermined gap therebetween by the bending space (A), and the beam 150 is elastically and minutely moved upwards and downwards in the bending space (A).

A sidewall 106 of the bending space (A) has a slope, and an upper part of the sidewall 106 contacts the beam 150, and thus the sidewall 106 of the bending space (A) and the beam 150 has a predetermined angle (θ) therebetween.

The trench oxide layer 111 is provided at the boundary between the beam 150 and the sidewall 106 of the bending space (A), i.e., the boundary (B) between the beam 150 and the support substrate 100. More particularly, the trench oxide layer 111 is formed around the sidewall 106 of the bending space (A). Therefore, the trench oxide layer 111 prevents the boundary (B) from being damaged because of the stress applied to the boundary (B) of the beam 150 and the support substrate 100 by the repeated bending operation of the beam 150, and also prevents electricity leakage by maintaining electrical insulation between the beam 150 and the support substrate 100,

As shown in FIG, 1A, the trench oxide layer 111 is provided in the Y direction perpendicular to the X direction of the beam 150.

An auxiliary trench oxide layer 112 is formed around the connection member 130, and the auxiliary trench oxide layer 112 is provided in the X direction perpendicular to the Y direction of the trench oxide layer 111, thereby preventing the connection member 130 from being damaged when the support substrate 100 is bent in the Y direction by the trench oxide layer 111.

The insulation layer 120 is not formed on the surface of the bending space (A) but formed between the support substrate 100 and the beam 150, and the connection member 130 is contact with the beam 150.

Another end of the beam 150 is connected to a circuit 170 formed below the support substrate 100 through the connection member 130. A solder resist 181 and a solder pad 182 are formed below the circuit 170. A solder ball 183 is attached to the solder pad 182.

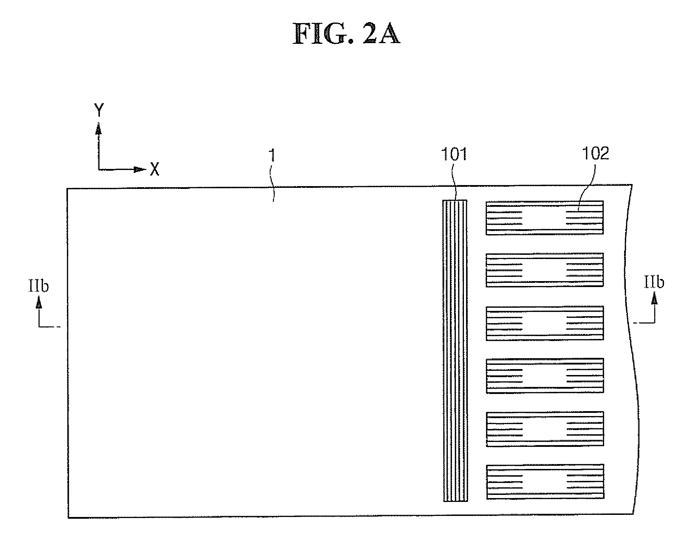

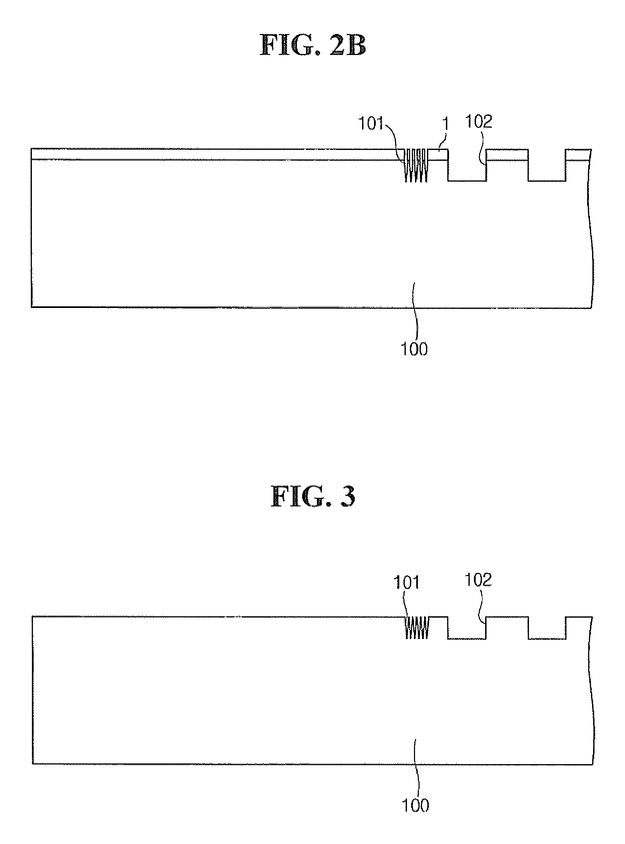

FIGs. 2 to 18 sequentially illustrate a probe substrate manufacturing method according to a preferred embodiment of the present invention.

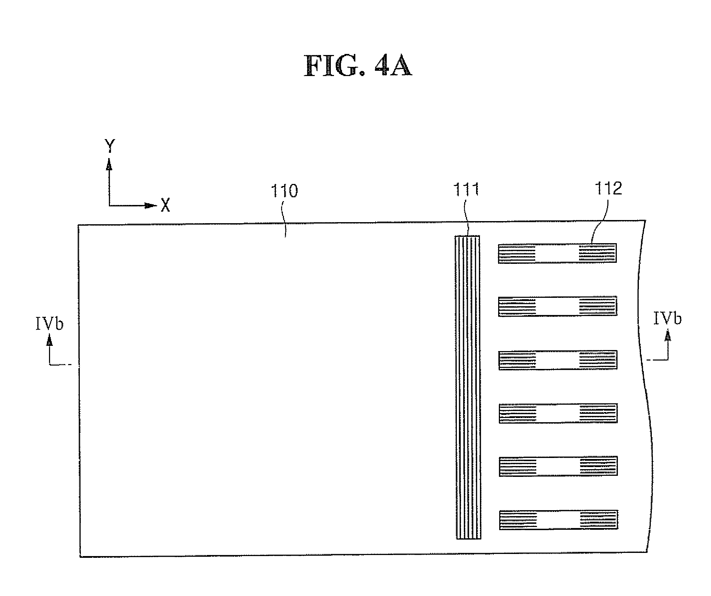

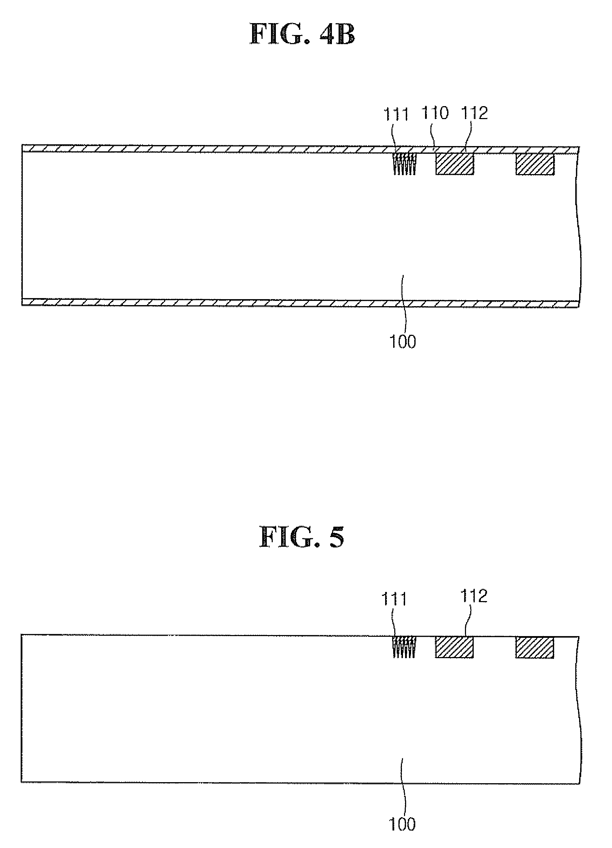

FIG. 2A is a top plan view of a probe substrate manufacturing method according to a preferred embodiment of the present invention, and FIG. 2B is a cross-sectional view taken along the line llb-llb of FIG. 2A. FIG. 3 is a cross-sectional view showing a next step of FIG. 2B. FIG. 4A is a top plan view showing a next step of FIG. 3, and FIG, 4B is a cross-sectional view taken along the line IVb-IVb of FIG. 4A. FIG. 5 is a cross-sectional view showing a next step of FIG. 4B.

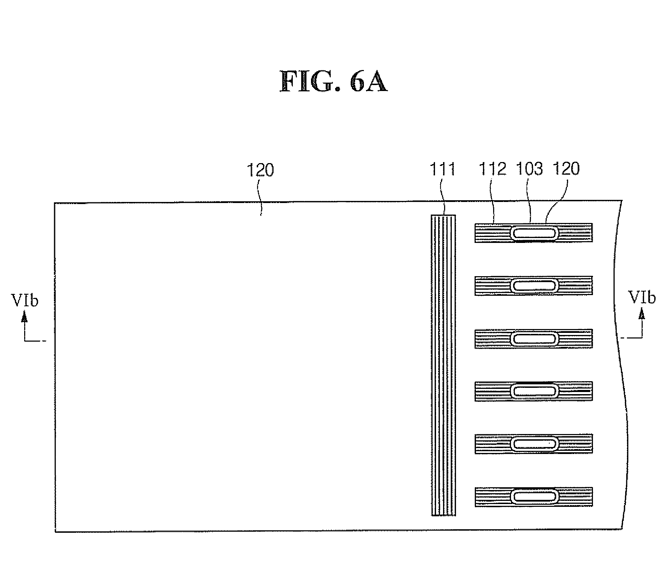

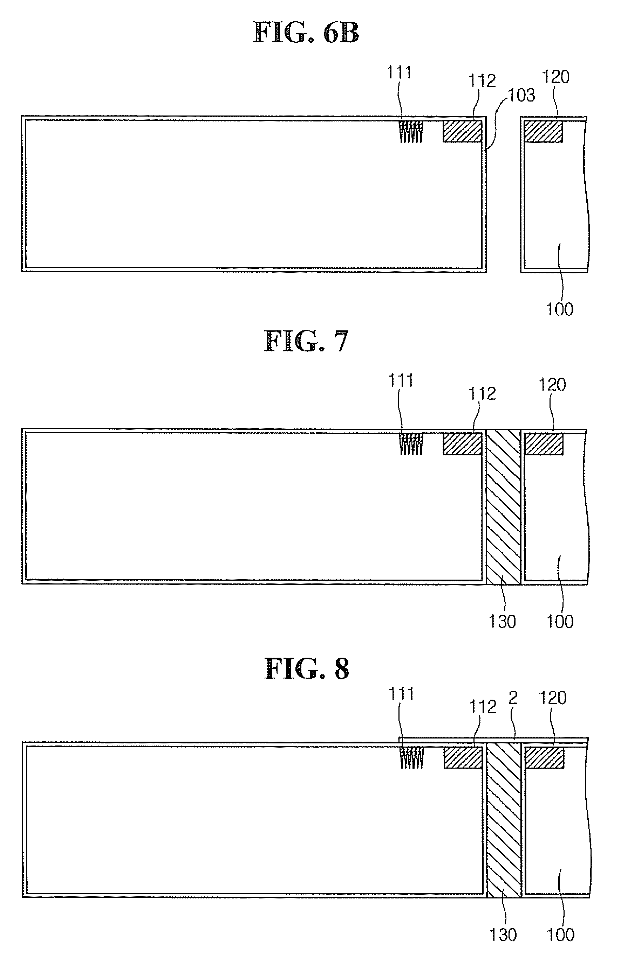

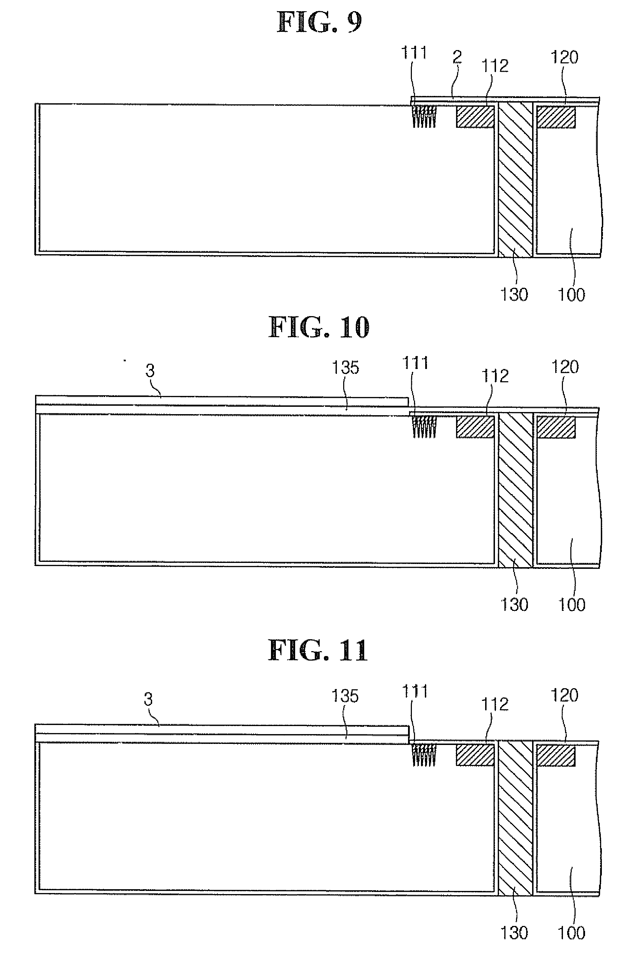

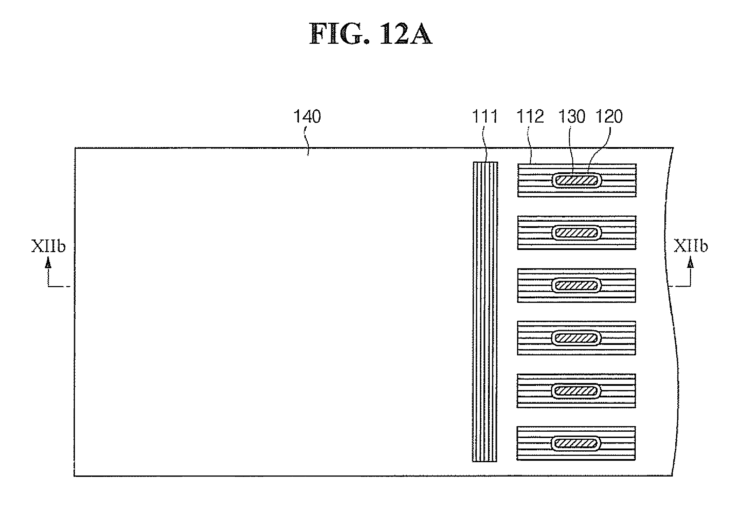

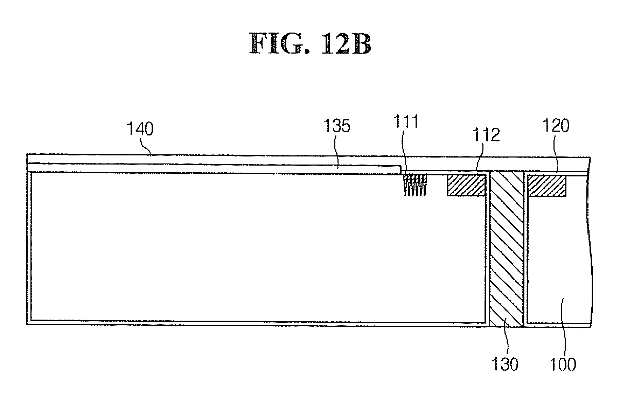

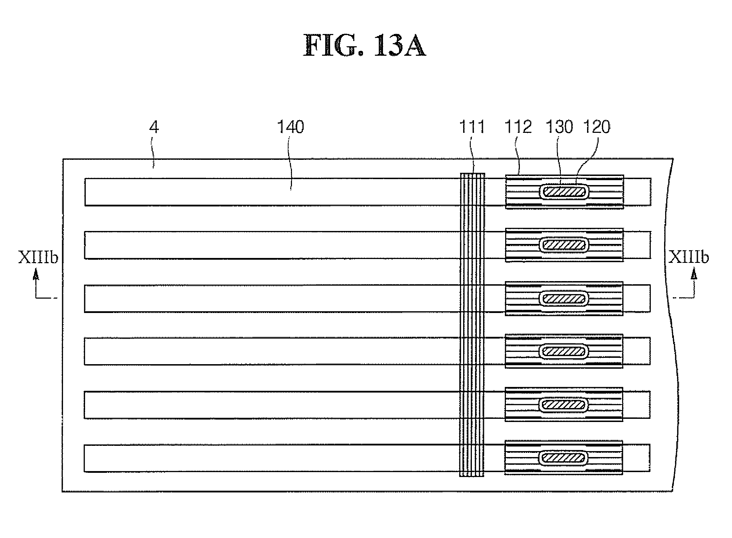

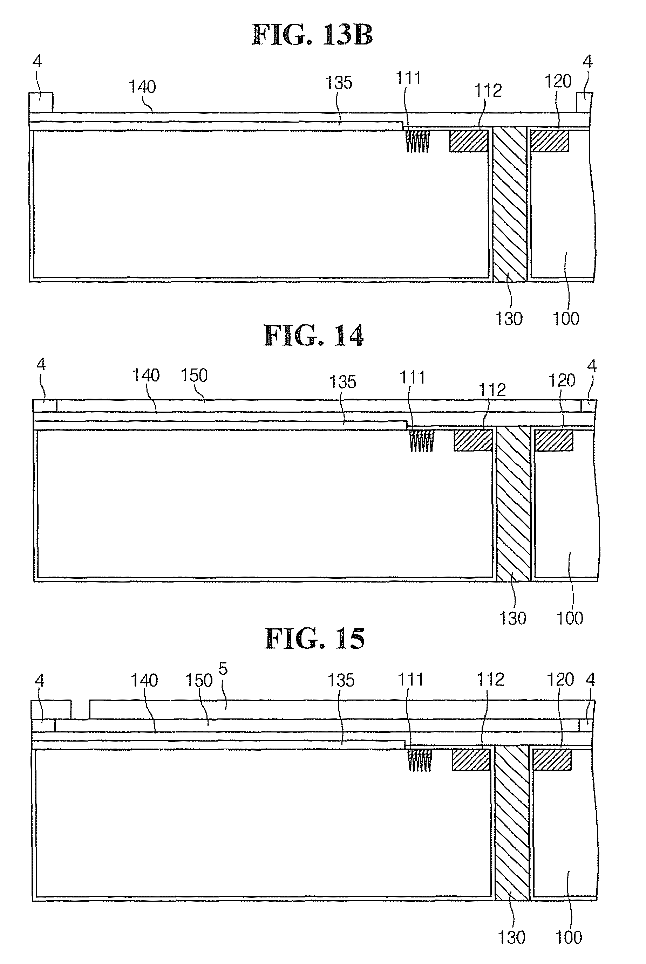

FIG. 6A is a top plan view showing a next step of FIG. 5, and FIG. 6B is a cross-sectional view taken along the line VIb-VIb of FIG, 6A. FIGS. 7 to 11 sequentially illustrate cross-sectional views of next steps of FIG. 6B. FIG. 12A is a top plan view showing a next step of FIG. 11, and FIG. 12B is a cross-sectional view taken along the line Xllb-Xllb of FIG. 12A. FIG. 13A is a top plan view showing a next step of FIG. 12A, and FIG. 13B is a cross-sectional view taken along the line Xlllb-Xlllb of FIG. 13A. FIGs. 14 to 18 sequentially illustrate cross-sectional views showing a next step of FIG. 13B.

As shown in FiGs, 2A and 2B, a photoresist layer is formed on the support substrate 100, and the photoresist layer is exposed and developed to form a first photoresist layer pattern 1. The photoresist layer may be a positive photoresist layer (when a light is illuminated, the illuminated part of the photoresist layer is developed and removed) or a negative photoresist layer (when a light is illuminated, the illuminated part is cured and remains after developing). The first photoresist layer pattern 1 is set as an etching mask, and a dry etching method such as reactive ion etching (RIE) using ozone plasma is used to form a plurality of microtrenches 101 and auxiliary microtrenches 102 on the surface of the support substrate 100. The depth of the microtrenches 101 is preferably ranged from 30 to 50 . When the depth of the microtrench 101 is less than 30 , hardness-improving effect is not achieved at the boundary between the beam 150 and the support substrate 100. When the depth of the microtrench 101 is greater than 50 , the shape of the support substrate 100 is deformed by volume expansion during the subsequent oxide layer forming process. Thus, the planarity of the surface of the support substrate 100 may deteriorate and the support substrate 100 may be damaged. As shown in FIG. 2A, the microtrench 101 is provided in the Y direction, and the auxiliary microtrench 102 is provided in the X direction.

As shown in FIG. 3, the first photoresist layer pattern 1 is removed, and the support substrate 100 is cleaned so as to remove a polymer formed by an etching gas (C₄F₈) generated in the dry etching process and fine particles that may be generated under other conditions. Plasma and cleaning chemicals are used during the process.

As shown in FIGs. 4A and 4B, thermal oxide layers (SiO₂) 110, 111, and 112 are formed on the support substrate 100, in the microtrenches 101, and in the auxiliary microtrenches 102, respectively. In order to form the thermal oxide layers 110,111, and 112, the silicon (Si) of the support substrate 100 is oxidized to be expanded to about 1.4 times under the condition of a high temperature of greater than 1100°C, gas of PN₂ with high purity, and moisture. Particularly, the thermal oxide layer 111 formed on the inner surface of the microtrenches 101 fills the microtrenches 101. The trench oxide layer 111 having filled the microtrenches 101 has excellent electrical insulation and hardness. Therefore, the boundary (B) between the beam 150 and the support substrate 100 is prevented from being damaged by the stress applied to the boundary (B) according to the bending operation of the beam 150 by locating the trench oxide layer 111 at the boundary (B), and electrical leakage is prevented by maintaining the electrical insulation between the beam 150 and the support substrate 100. The trench oxide layer 111 is formed to be provided in the Y direction.

The thermal oxide layer 112 formed on the inner surface of the auxiliary microtrenches 102 fills the auxiliary microtrenches 102. Thus, the auxiliary trench oxide layer 112, is formed in the X direction with respect to the Y direction in which the trench oxide layer 111 is provided so as to prevent the support substrate 100 from being bent by the trench oxide layer 111.

As shown in FIG. 5, the surface of the support substrate 100 is polished to remove the thermal oxide layer 110 other than the trench oxide layer 111 and the auxiliary trench oxide layer 112 and planarize the surface of the support substrate 100. The upper parts of the trench oxide layer 111 and the auxiliary trench oxide layer 112 are expanded and protruded during the thermal oxide layer forming process, so the upper parts thereof are polished to be planarized.

As shown in FIGS, 6A and 6B, an etch mask is formed on the support substrate 100, and the support substrate 100 is etched to form a plurality of through holes 103 at predetermined locations of the support substrate 100. The through hole 103 is formed with a predetermined gap from the trench oxide layer 111, and is formed surrounded by the auxiliary trench oxide layer 112. The auxiliary trench oxide layer 112 prevents the through hole 103 from being deformed by the trench oxide layer 111. Preferably, a metal layer of Al, Cr, or a silicon compound of a silicon nitride film or a silicon oxide film is used as the etch mask, or only the photoresist layer is used.

A thermal oxidation process or a chemical vapor deposition (CVD) process is performed to form an insulation layer 102 such as a silicon oxide layer or a silicon nitride layer on the entire surface of the support substrate 100. In this instance, the insulation layer 120 is formed on the inner surface of the through hole 103.

As shown in FIG. 7, the through hole 103 is filled with a conductive material for connecting electrical signals to form a connection member 130.

As shown in FIG. 8, a photoresist layer is formed on the support substrate 100 on which the insulation layer 120 is formed, and the photoresist layer is exposed and developed to form a second photoresist layer pattern 2. The second photoresist layer pattern 2 covers the trench oxide layer 111, the auxiliary trench oxide layer 112, and the connection member 130, and does not cover the part corresponding to the bending space (A). Therefore, the insulation layer 120 is exposed at the part that is not covered by the second photoresist layer pattern 2.

As shown in FIG. 9, using the second photoresist layer pattern 2 as an etch mask, the exposed insulation layer 120 is etched to expose part of the support substrate 100.

As shown in FIG. 10, the second photoresist layer pattern 2 is removed, and a sacrificial metal layer 135 of aluminum is formed on the exposed part of the support substrate 100 and the insulation layer 120. A third photoresist layer pattern 3 is formed on the sacrificial metal layer 135. The third photoresist layer pattern 3 is formed at a location other than the location where the second photoresist layer pattern 2 is formed. More particularly, the third photoresist layer pattern 3 does not cover the trench oxide layer 111, the auxiliary trench oxide layer 112, and the connection member 130, and the sacrificial metal layer 135 is exposed on the part that is not covered by the third photoresist layer pattern 3.

As shown in FIG. 11, the third photoresist layer pattern 3 is set as an etch mask to etch the exposed sacrificial metal layer 135. Therefore, the sacrificial metal layer 135 does not cover the trench oxide layer 111, the auxiliary trench oxide layer 112, and the connection member 130.

As shown in FIGs. 12A and 12B, the third photoresist layer pattern 3 is removed, and a seed layer 140 is formed on the exposed sacrificial metal layer 135 and the insulation layer 102. The seed layer 140 is preferably formed with bi-layers of an adhesion layer and a conductive layer. The upper layer is preferably formed as a conductive layer by using a metal made of one of nickel (Ni), copper (Cu), platinum (Pt), palladium (Pd), rhodium (Rh), and gold (Au), or an alloy made of one of the metals as a major element and other elements. And the lower layer is preferably formed as an adhesion layer for controlling the conductive layer to be properly deposited on the support substrate 100 by using titanium (Ti).

As shown in FIGs. 13A and 13B, a photoresist layer is formed on the seed layer 140, and the photoresist layer is exposed and developed to form a fourth photoresist layer pattern 4. The thickness of the fourth photoresist layer pattern 4 is preferably ranged from 70 to 100. As shown in FIG. 13B, the fourth photoresist layer pattern 4 includes a plurality of long bar patterns in the horizontal direction, and one end of the long bar of the fourth photoresist layer pattern 4 corresponds to the connection member 130. The seed layer 140 is exposed by the fourth photoresist layer pattern 4.

As shown in FIG, 14, the seed layer 140 is plated with the same metal (metal made of one of nickel (Ni), copper (Cu), platinum (Pt), palladium (Pd), rhodium (Rh), and gold (Au) or an alloy made of one of the metals as a major element and other metals) as the seed layer 140 by using the electroplating method to fill the part exposed by the fourth photoresist layer pattern 4 and form a plurality of beams 150. In this instance, since the copper (Cu) and gold (Au) have good softness and the nickel (Ni), platinum (Pt), palladium (Pd), and rhodium (Rh) have good mechanical characteristics, the metal is selectively applied depending on a target material to be contacted. Accordingly, the beam is made of metal, thereby improving the strength of the beam 150.

The irregular upper part of the beam 150 generated by the plating process is planarized by polishing the upper part thereof. Therefore, the beam 150 having a uniform thickness is formed.

As shown in FIG. 15, a fifth photoresist layer pattern 5 is formed on the fourth photoresist layer pattern 4 and the beam 150. The fifth photoresist layer pattern 5 exposes one end of the beam 150.

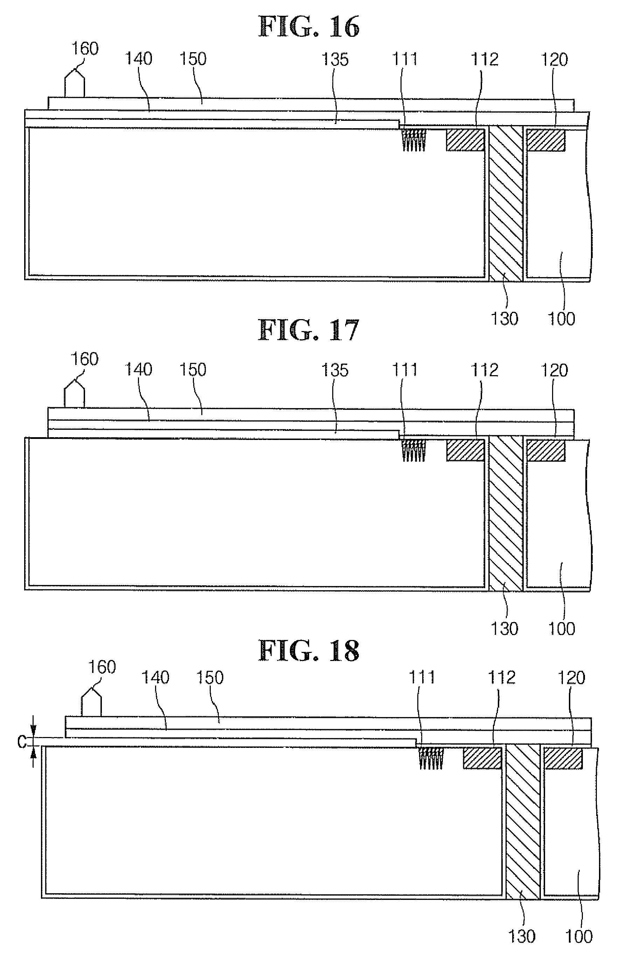

As shown in FIG. 16, the beam 150 is plated with the same metal as the seed layer 140 by using the electroplating method, and hence the part exposed by the fifth photoresist layer pattern 5 is filled to form a contactor 160. The fourth photoresist layer pattern 4 and the fifth photoresist layer pattern 5 are removed to expose part of the beam 150 and the seed layer 140. The end of the contactor 160 is polished to be round-shaped.

As shown in FIG. 17, the beam 150 is set as an etch mask to pattern the seed layer 140 and the sacrificial metal layer 135, and to expose the sidewall of the sacrificial metal layer 135 and part of the support substrate 100.

As shown in FIG. 18, the sacrificial metal layer 135 is etched to form a space (C) between the support substrate 100 and the beam 150.

As shown in FIG. 1B, the support substrate 100 exposed through the space (C) between the support substrate 100 and the beam 150 is etched to form the bending space (A). In this instance, the etching is started from one end of the support substrate 100 to form the bending space (A), and the etching is performed to the part contacted with the trench oxide layer 111. A circuit 170 is formed below the support substrate 100 to connect the connection member 130 and the circuit 170. A solder resist 181 and a solder pad 182 are formed below the circuit 170, and a solder ball 183 is attached to the solder pad 182.

The probe substrate and the manufacturing method according to the embodiment of the present invention forms a trench oxide layer at the boundary between the beam and the support substrate to prevent the boundary from being damaged by the stress applied to the boundary of the beam and the support substrate according to the continuous and repeated bending operation of the beam.

Therefore, electrical insulation between the beam and the support substrate is maintained to prevent electrical leakage, thereby improving the quality of the probe substrate and acquiring stability in the test result,

While this invention has been described in connection with what is presently considered to be practical preferred embodiments, it is to be understood that the invention is not limited to the disclosed embodiments, but, on the contrary, is intended to cover various modifications and equivalent arrangements included within the spirit and scope of the appended claims.

## Claims

1. A probe substrate comprising:
a probe including a beam having a first end and a second end, and a contactor formed at the first end of the beam;
a support substrate supporting the second end of the probe and having a bending space, wherein the first end of the probe is bent in the bending space upwards and downwards; and
a trench oxide layer formed on an upper surface of the support substrate,
wherein the trench oxide layer is provided adjacent to the bending space among parts in which the support substrate supports the probe.

2. The probe substrate of claim 1, wherein
the beam and a predetermined part of the support substrate are spaced with a predetermined gap thereby forming the bending space.

3. The probe substrate of claim 1, wherein
a sidewall of the bending space slopes.

4. The probe substrate of claim 1, wherein
a through hole is formed in the support substrate, and the through hole is filled by a connection member.

5. The probe substrate of claim 1, wherein
the trench oxide layer is a thermal oxide layer formed at a plurality of microtrenches on the surface of the support substrate.

6. The probe substrate of claim 1, wherein
the beam is made of one metal of nickel (Ni), copper (Cu), platinum (Pt), palladium (Pd), rhodium (Rh), and gold (Au), or an alloy made of one of the metal as a major element and other metals as minor elements.

7. The probe substrate of claim 1, wherein
an insulation layer is formed on the surface of the support substrate other than on the surface of the bending space of the support substrate.

8. The probe substrate of claim 7, wherein
the insulation layer is formed at a region between the support substrate and the beam, and the connection member contacts the beam.

9. The probe substrate of claim 1, wherein
the longitudinal direction of the trench oxide layer is perpendicular to the longitudinal direction of the beam.

10. The probe substrate of claim 9, wherein
an auxiliary trench oxide layer is formed around the connection member.

11. The probe substrate of claim 10, wherein
the longitudinal direction of the auxiliary trench oxide layer is perpendicular to the longitudinal direction of the trench oxide layer.

12. A method for manufacturing a probe substrate, comprising:
forming a plurality of microtrenches on a support substrate;
filling the microtrenches with a thermal oxide layer to form a trench oxide layer;
forming a plurality of through holes in the support substrate;
forming an insulation layer on the surface of the support substrate;
forming a connection member in the respective through hole;
forming a plurality of beams on the insulation layer formed on the support substrate;
forming a contactor at one end of the beam; and
etching one part of the support substrate provided at the lower part of the beam to form a bending space for enabling the end part at which the contactor of the beam is formed to move upwards and downwards,
wherein the forming of a trench oxide layer includes controlling the trench oxide layer to be positioned adjacent to the bending space among the part in which the support substrate supports the beam.

13. The method of claim 12, wherein
the forming of a plurality of beams further comprises:
patterning the insulation layer formed on the support substrate and exposing a predetermined part of the support substrate corresponding to the bending space;
forming a sacrificial metal layer on the exposed part of the support substrate;
forming a seed layer on the sacrificial metal layer and the insulation layer;
forming a first photoresist layer pattern on the seed layer and an exposing part of the seed layer; and
filling a part exposed through the first photoresist layer pattern with metal to form a plurality of beams.

14. The method of claim 13, wherein
the first photoresist layer pattern includes a plurality of long bar patterns in the horizontal direction.

15. The method of claim 14, wherein
one end of the long bar pattern of the first photoresist layer pattern corresponds to the connection member.

16. The method of claim 13, wherein
the patterned insulation layer covers the trench oxide layer and the connection member.

17. The method of claim 16, wherein
the sacrificial metal layer does not cover the trench oxide layer.

18. The method of claim 12, further comprising:
forming an auxiliary trench oxide layer around the through hole.

19. The method of claim 18, wherein
the longitudinal direction of the auxiliary trench oxide layer is perpendicular to the longitudinal direction of the trench oxide layer.

20. The method of claim 17, wherein
the etching of part of the support substrate to form a bending space includes:
etching the sacrificial metal layer to form a space between the beam and the support substrate; and
etching the support substrate exposed through the space and forming a bending space.

21. The method of claim 12, wherein
the contactor is formed on the beam by using an electroplating method.

22. The method of claim 12, wherein
the beam is made of one metal of nickel (Ni), copper (Cu), platinum (Pt), palladium (Pd), rhodium (Rh), and gold (Au), or an alloy made of one of the metals as a major element and other metals as minor elements.
